# EUROPÄISCHE PATENTSCHRIFT

(11) **EP 2 319 062 B1**
(45) Veröffentlichungstag und Bekanntmachung des Hinweises auf die Patenterteilung: **29.05.2013**
(21) Anmeldenummer: 09776107.6
(22) Anmeldetag: 21.08.2009
(51) Int. Cl.: H01H 13/10

(54) **ELEKTRISCHER SCHALTER**
ELECTRIC SWITCH
INTERRUPTEUR ÉLECTRIQUE

(30) Priorität: 26.08.2008 DE 102008039719
(43) Veröffentlichungstag der Anmeldung: 11.05.2011
(73) Patentinhaber: Marquardt GmbH, 78604 Rietheim-Weilheim (DE)
(72) Erfinder: KIZELE, Rainer, 78532 Tuttlingen (DE); KUGLER, Thomas, 78532 Tuttlingen (DE)
(74) Vertreter: Otten, Roth, Dobler & Partner
(86) Internationale Anmeldenummer: PCT/DE2009/001177
(87) Internationale Veröffentlichungsnummer: WO 2010/022706

(56) Entgegenhaltungen:
- DE-A1- 2 352 280
- DE-A1-102005 001 727

## Beschreibung

Die Erfindung betrifft einen elektrischen Schalter nach dem Oberbegriff des Patentanspruchs 1.

Ein solcher elektrischer Schalter kann in Elektro- sowie Hausgeräten der sogenannten weißen Ware, wie Waschmaschinen, Geschirrspülmaschinen, Trockner o. dgl., eingesetzt sein. Beispielsweise dient der Schalter in diesen Geräten als Netz- und/oder Hauptschalter und kann auf einer Leiterplatte befestigt angeordnet sein.

Ein derartiger elektrischer Schalter ist beispielsweise aus der DE 42 02 214 A1 oder aus der DE 23 52 280 A1 bekannt. Der Schalter besitzt ein Gehäuse, in dem sich ein Kontaktsystem befindet. Ein zur schaltenden Einwirkung auf das Kontaktsystem dienendes bewegbares Betätigungsorgan ragt an einer ersten Seite aus dem Gehäuse heraus. An einer zweiten Seite ragen elektrische Anschlüsse für das Kontaktsystem aus dem Gehäuse heraus. Dieser Schalter ist zur Montage auf einer Leiterplatte geeignet, indem die elektrischen Anschlüsse beispielsweise durch Verlöten auf der Leiterplatte befestigbar sind. Zwar ist der Schalter nach der Montage auf der Leiterplatte durch das Gehäuse abstützend fixiert, es besteht dabei jedoch die Gefahr, daß die auf das Betätigungsorgan durch den Benutzer ausgeübte Kraft zur Betätigung des Schalters über die Lötstellen an den elektrischen Anschlüssen auf die Leiterplatte übertragen wird. Dadurch können die Lötstellen wiederum geschädigt werden. Diese Gefahr besteht im besonderen bei Schaltern, bei denen die elektrischen Anschlüsse derart angeordnet sind, daß die Betätigungsrichtung parallel zur Ebene der Leiterplatte verläuft.

Der Erfindung liegt die Aufgabe zugrunde, den Schalter derart weiterzuentwickeln, daß die Befestigung für den auf einer Leiterplatte montierten Schalter verbessert ist. Insbesondere soll der Schalter mechanisch so befestigbar sein, daß die Kraft zur Betätigung des Schalters nicht über die Lötstellen an den elektrischen Anschlüssen auf die Leiterplatte übertragen wird.

Diese Aufgabe wird bei einem gattungsgemäßen elektrischen Schalter durch die kennzeichnenden Merkmale des Anspruchs 1 gelöst.

Beim erfindungsgemäßen elektrischen Schalter ist wenigstens ein elastisches Abstützelement an der zweiten Seite des Gehäuses befindlich, derart daß der Schalter im Bereich der Anschlüsse nach Montage des Schalters auf der Leiterplatte weitgehend an der Leiterplatte fixiert ist. Mittels des Abstützelements liegt der Schalter zur Kraftüberleitung an der Leiterplatte an. Um eine sichere Anlage zu gewährleisten ist zweckmäßigerweise das Abstützelement elastisch ausgebildet, wobei dieses aus einem Federelement sowie einem Abstandselement bestehen kann. Vorteilhafterweise wird dadurch die bei der Betätigung des Schalters ausgeübte Betätigungskraft von dem Abstützelement aufgenommen und in die Leiterplatte eingeleitet. Die elektrischen Anschlüsse sind somit im Hinblick auf die Betätigungskraft weitgehend kräftefrei, wodurch die empfindlichen Anschlüsse vor Beschädigungen bewahrt sind. Eine derartige Ausgestaltung ist besonders bei Schaltern wichtig, bei denen die Betätigungsrichtung parallel zur Ebene der Leiterplatte verläuft, da hierbei ansonsten neben der Kraft auch ein Drehmoment auf die Anschlüsse übertragen werden kann, wobei die Gefahr des Abscherens und/oder Abknickens der Anschlüsse besteht. Weitere Ausgestaltungen der Erfindung sind Gegenstand der Unteransprüche.

Desweiteren können die elektrischen Anschlilsse unter Herstellung einer elektrischen Verbindung an Lötstellen auf der Leiterplatte befestigt sein.

In einer weiteren Ausgestaltung, die die eingeleiteten Kräfte besonders effektiv aufnimmt, ist das Abstützelement ein Teil eines Befestigungssystems. Das Befestigungssystem kann aus einem Rasthaken zur Verrastung des Schalters in einer Befestigungsöffnung an der Leiterplatte sowie den an der Leiterplatte elastisch anliegenden Abstützelementen bestehen. Zweckmäßigerweise wirkt das elastische Abstützelement und der Rasthaken derart zusammen, daß der Schalter bei Montage auf der Leiterplatte sowohl in Richtung der auf das Betätigungsorgan bei dessen Betätigung einwirkenden Betätigungskraft im wesentlichen ohne Spiel in der Befestigungsöffnung fixiert wird als auch durch ein entstehendes Drehmoment so gegen die Betätigungskraft vorgespannt wird, daß der Schalter im Bereich der Lötanschlüsse an der Leiterplatte fixiert bzw. abgestützt ist und insoweit fest an der Leiterplatte anliegt.

Der Schalter kann mit seiner zweiten Seite im wesentlichen parallel zu der Leiterplatte angeordnet werden. Dabei können die erste Seite sowie die zweite Seite zueinander benachbart sein, insbesondere zueinander in etwa rechtwinklig stehen. Obwohl in diesem Fall die Betätigungskraft im wesentlichen parallel zur Leiterplatte gerichtet ist, bleiben die empfindlichen Anschlüsse vor Beschädigung bei der Betätigung des Schalters bewahrt. Eine besonders effektive Kraftaufnahme ist dann dadurch gegeben, daß das Abstützelement im wesentlichen am Übergang von der ersten Seite zur zweiten Seite am Gehäuse angeordnet ist. Desweiteren bietet es sich dabei auch an, daß der Rasthaken an der zweiten Seite des Gehäuses zwischen den Abstützelementen und den elektrischen Anschlüssen angeordnet ist.

In kompakter Art und Weise ist das Gehäuse im wesentlichen quaderförmig ausgestaltet. Desweiteren kann das Gehäuse topfförmig mit einer der ersten Seite zugewandten Öffnung ausgebildet sein. Zur Gewährleistung einer guten Abdichtung gegen das Eindringen von Verschmutzungen, Schadstoffen o. dgl. in das Gehäuse kann die die Öffnung verschließende erste Seite integraler Bestandteil des Betätigungsorgans sein.

Für eine besonders bevorzugte Ausführung ist nachfolgendes festzustellen. Es ist ein Schalter mit speziellen Befestigungselementen geschaffen, bestehend aus einem Rasthaken zur Verrastung des Schalters auf der Leiterplatte sowie elastischen Abstützungen, welche so zusammenwirken, daß der Schalter bei Montage auf der Leiterplatte sowohl in Richtung der Betätigungskraft ohne Spiel in der Befestigungsöffnung fixiert wird, als auch durch ein entstehendes Drehmoment so vorgespannt wird, daß der Schalter im Bereich der Lötanschlüsse fest an der Leiterplatte anliegt.

Die mit der Erfindung erzielten Vorteile bestehen insbesondere darin, daß der Schalter bereits bei der Montage auf der Leiteplatte so fixiert wird, daß eine mechanische Belastung der Lötstellen vermieden wird. Folglich wird die Lebensdauer des Schalters verbessert. Außerdem ist der Schalter vor Beschädigung bei dessen Gebrauch geschützt. Eine zusätzliche Fixierung durch Schrauben, Klammern oder andere Zusatzteile, die ansonsten erforderlich wäre, ist nicht notwendig. Damit werden auch Kosten eingespart.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: einen auf einer Leiterplatte montierten elektrischen Schalter in perspektivischer Ansicht,
- Fig. 2: den Schalter wie in Fig. 1, jedoch in einer anderen Perspektive,
- Fig. 3: die Ansicht gemäß Richtung III in Fig. 1,
- Fig. 4: die Ansicht gemäß Richtung IV in Fig. 1,
- Fig. 5: einen Schnitt entlang der Linie 5-5 in Fig. 3, insbesondere bei Betätigung des Schalters, und
- Fig. 6: einen Schnitt wie in Fig. 5, wobei die auf den Schalter wirkenden Kräfte, insbesondere bei dessen Montage, näher bezeichnet sind.

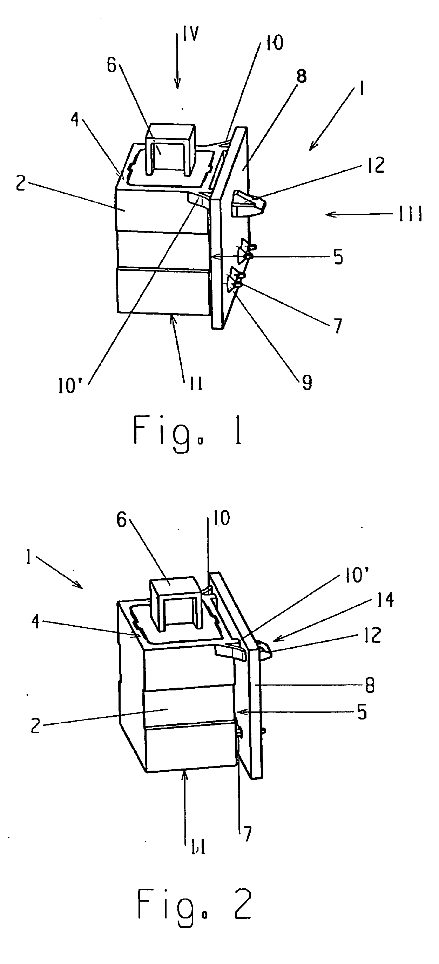

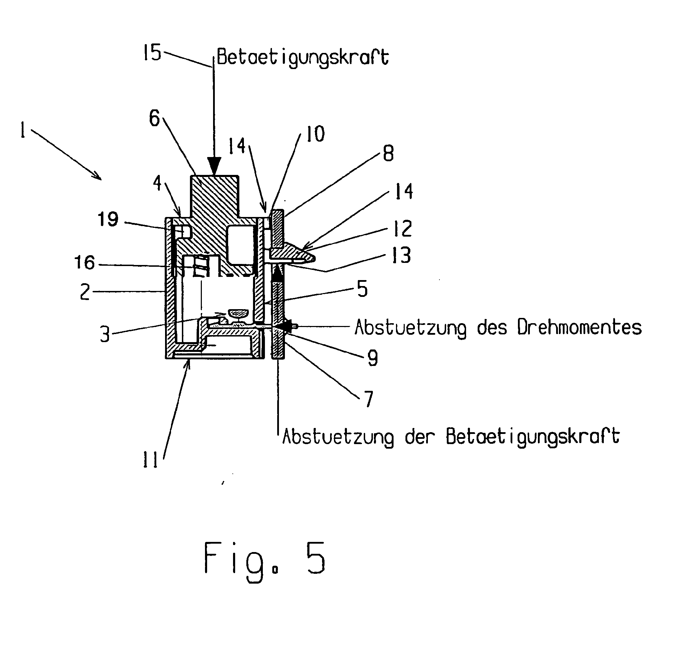

In Fig. 1 ist ein als Druckschalter zum Einlöten in Leiterplatten ausgestalteter elektrischer Schalter 1 in perspektivischer Ansicht zu sehen. Der Schalter 1 weist ein Gehäuse 2 auf, in dem sich ein in Fig. 5 lediglich schematisch gezeigtes, an sich bekanntes Kontaktsystem 3 befindet. An einer ersten Seite 4, und zwar an der Oberseite, ragt ein manuell vom Benutzer gegen die Rückstellkraft einer Druckfeder 16 bewegbares Betätigungsorgan 6 zur schaltenden Einwirkung auf das Kontaktsystem 3 aus dem Gehäuse 2 heraus. Dabei ist das Gehäuse 2 in etwa topfförmig in der Art eines Quaders ausgestaltet und an der Oberseite 4 offen. Die erste Seite 4 bildet gemäß Fig. 5 ein integrales Bestandteil mit dem Betätigungsorgan 6 und verschließt die der Oberseite 4 zugewandte Öffnung 19 im Gehäuse 2, womit das Betätigungsorgan 6 gleichzeitig die Funktion des Deckels für das Gehäuse 2 ausübt. An einer zur Oberseite 4 angrenzenden zweiten Seite 5, und zwar an der Längsseite des Gehäuses 2, ragen elektrische Anschlüsse 7 für das Kontaktsystem 3 aus dem Gehäuse 2 heraus, wie in Fig. 5 zu sehen ist

Der elektrische Schalter 1 kann auf einer Leiterplatte 8 montiert werden, und zwar derart daß die Längsseite 5 des Gehäuses 2 in etwa parallel zur Leiterplatte 8 angeordnet ist. Hierzu sind die elektrischen Anschlüsse 7 auf der Leiterplatte 8 durch Verlöten befestigbar. Die Lötstellen 9, die die elektrische Verbindung der Anschlüsse 7 zu Leiterbahnen auf der Leiterplatte 8 herstellen, sind in Fig. 1 näher zu sehen. An der zweiten Seite 5 des Gehäuses 2 befindet sich wenigstens ein elastisches Abstützelement 10. Während die elektrischen Anschlüsse 7 in der Nähe der Unterseite 11, die der Oberseite 4 gegenüberliegt, an der Längsseite 5 befindlich sind, befinden sich vorliegend zwei Abstützelemente 10, 10' in der Nähe der Oberseite 4 und zwar in etwa an den Ecken des quaderförmigen Gehäuses 2. Mit anderen Worte sind die erste Seite 4 sowie die zweite Seite 5 zueinander benachbart, und zwar stehen diese in etwa rechtwinklig zueinander, wobei das Abstützelement 10, 10' im wesentlichen am Übergang von der ersten Seite 4 zur zweiten Seite 5 am Gehäuse 2 angeordnet ist.

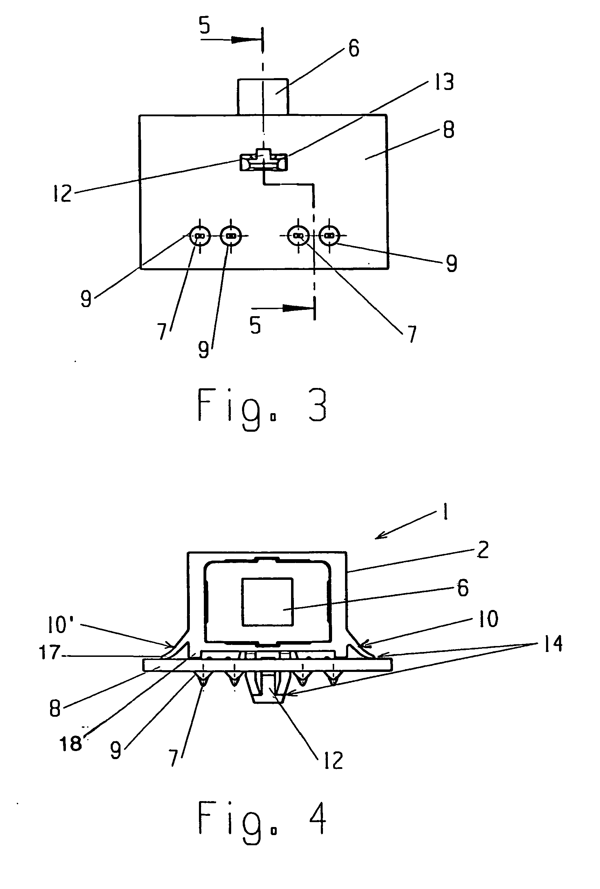

Wie man anhand der Fig. 2 erkennt, liegt aufgrund der Abstützung mit Hilfe der Abstützelemente 10, 10' der Schalter 1 im wesentlichen fest an der Leiterplatte 8 an und ist somit nach Montage des Schalters 1 auf der Leiterplatte 8 im Bereich der Anschlüsse 7 weitgehend an der Leiterplatte 8 fixiert. In ergänzender Ausgestaltung kann das Abstützelement 10, 10' elastisch ausgebildet sein, indem dieses aus einem Federelement 17 sowie einem Abstandselement 18 besteht, wie in der Fig. 4 gezeigt ist. Üblicherweise ist das Gehäuse 2 durch Spritzgießen aus thermoplastischem Kunststoff hergestellt, so daß es sich anbietet, bei der Herstellung des Gehäuses 2 das eine Eigenelastizität aufweisende Federelement 17 sowie das starre Abstandselement 18 mit anzuspritzen.

In einer Weiterbildung ist das Abstützelement 10, 10' ein Teil eines Befestigungssystems 14 für den Schalter 1. Gemäß Fig. 4 besteht das Befestigungssystem 14 dabei weiter aus einem Rasthaken 12 zur Verrastung des Schalters 1 auf der Leiterplatte 8 sowie den elastischen Abstützungen 10, 10'. Gemäß Fig. 5 ist der Rasthaken 12 an der Längsseite 5 des Gehäuses 2 zwischen den Abstützelementen 10, 10' und den elektrischen Anschlüssen 7 angeordnet. Wie man weiter der Fig. 3 entnimmt, durchgreift der Rasthaken 12 nach Montage des Schalters 1 auf der Leiterplatte 8 einen in der Leiterplatte 8 befindlichen Durchbruch 13 verrastend. Aufgrund der dabei vom Rasthaken 12 ausgeübten Kraft liegen die Abstützelemente 10, 10' elastisch an der Leiterplatte 8 an. Der Rasthaken 12 und die elastischen Abstützelemente 10, 10' wirken hierbei derart zusammen, daß der Schalter 1 bei Montage auf der Leiterplatte 8 sowohl in Richtung der auf das Betätigungsorgan 6 bei dessen Betätigung einwirkenden Betätigungskraft 15 (siehe Fig. 5) im wesentlichen ohne Spiel in der Befestigungsöffnung 13 fixiert wird als auch durch ein im Bereich der Abstützelemente 10, 10' wirkendes Drehmoment so gegen die Betätigungskraft 15 vorgespannt wird, daß der Schalter 1 im Bereich der Lötanschlüsse 9 an der Leiterplatte fixiert ist und somit dort fest abgestützt an der Leiterplatte 8 anliegt.

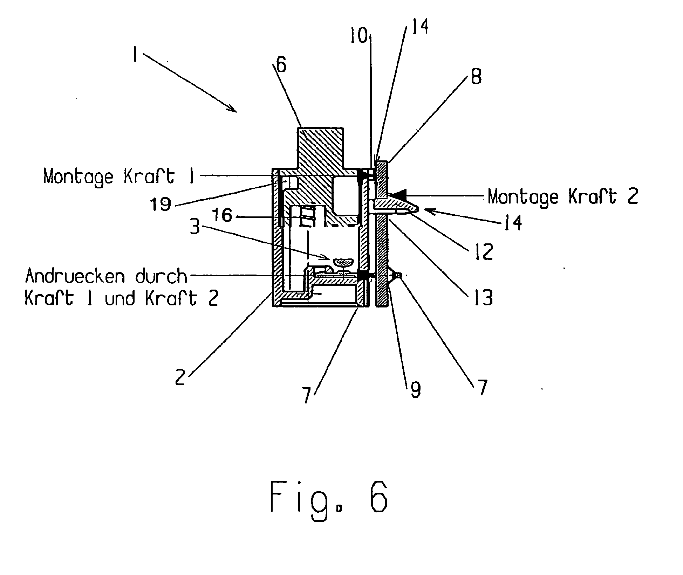

Diese Wirkungsweise ist in Fig. 6 näher verdeutlicht, wobei die Abstützelemente 10, 10' eine Montagekraft 1 und der Rasthaken 12 eine Montagekraft 2 ausüben. Diese beiden Kräfte 1, 2 bewirken folglich ein Andrücken der Anschlüsse 7 an die Leiterplatte 8 bei der Montage sowie eine Entlastung der Lötstellen 9 von der im wesentlichen parallel zur Leiterplatte 8 gerichteten, in Fig. 5 gezeigten Betätigungskraft 15.

Die Erfindung ist nicht auf das beschriebene und dargestellte Ausführungsbeispiel beschränkt. Sie umfaßt vielmehr auch alle fachmännischen Weiterbildungen im Rahmen der durch die Patentansprüche definierten Erfindung. So kann ein derartiger Schalter 1 nicht nur als Geräteschalter mit seitlichen Leiterplatten-Lötanschlüssen an Elektrogeräten, Haushaltsgeräten o. dgl. sondern auch als Bedienschalter für Kraftfahrzeuge, Werkzeugmaschinen o. dgl. Verwendung finden.

### Bezugszeichen-Liste:

| | |
|---|---|
| 1: | elektrischer Schalter |
| 2: | Gehäuse |
| 3: | Kontaktsystem |
| 4: | (erste) Seite / Oberseite (von Gehäuse) |
| 5: | (zweite) Seite / Längsseite (von Gehäuse) |
| 6: | Betätigungsorgan |
| 7: | (elektrischer) Anschluß |
| 8: | Leiterplatte |
| 9: | Lötstelle / Lötanschluß |
| 10,10': | Abstützelement / Abstützung |
| 11: | Unterseite (von Gehäuse) |
| 12: | Rasthaken |
| 13: | Durchbruch / Befestigungsöffnung |
| 14: | Befestigungssystem |
| 15: | Betätigungskraft |
| 16: | Druckfeder |
| 17: | Federelement (von Abstützelement) |
| 18: | Abstandselement (von Abstützelement) |
| 19: | Öffnung (im Gehäuse) |

## Patentansprüche

1. Elektrischer Schalter mit einem Gehäuse (2), mit einem im Gehäuse (2) befindlichen Kontaktsystem (3), mit einem an einer ersten Seite (4) aus dem Gehäuse (2) ragenden Betätigungsorgan (6) zur schaltenden Einwirkung auf das Kontaktsystem (3), und mit an einer zweiten Seite (5) aus dem Gehäuse (2) ragenden elektrischen Anschlüssen (7) für das Kontaktsystem (3), wobei die elektrischen Anschlüsse (7) auf einer Leiterplatte (8) befestigbar sind, und wobei wenigstens ein Abstützelement (10, 10') an der zweiten Seite (5) des Gehäuses (2) befindlich ist, derart daß der Schalter (1) im Bereich der Anschlüsse (7) nach Montage des Schalters (1) auf der Leiterplatte (8) weitgehend an der Leiterplatte (8) fixiert ist, **dadurch gekennzeichnet, daß** das Abstützelement (10, 10') elastisch ausgebildet ist und aus einem Federelement (17) sowie einem Abstandselement (18) besteht.

2. Elektrischer Schalter nach Anspruch 1, **dadurch gekennzeichnet, daß** die elektrischen Anschlüsse (7) unter Herstellung einer elektrischen Verbindung an Lötstellen (9) auf der Leiterplatte (8) befestigt sind.

3. Elektrischer Schalter nach Anspruch 1 oder 2, **dadurch gekennzeichnet, daß** das Abstützelement (10, 10') ein Teil eines Befestigungssystems (14) ist, wobei das Befestigungssystem (14) aus einem Rasthaken (12) zur Verrastung des Schalters (1) in einer Befestigungsöffnung (13) an der Leiterplatte (8) sowie den an der Leiterplatte (8) elastisch anliegenden Abstützelementen (10, 10') besteht.

4. Elektrischer Schalter nach Anspruch 3, **dadurch gekennzeichnet, daß** der Rasthaken (12) und das elastische Abstützelement (10, 10') derart zusammenwirken, daß der Schalter (1) bei Montage auf der Leiterplatte (8) sowohl in Richtung der auf das Betätigungsorgan (6) bei dessen Betätigung einwirkenden Betätigungskraft (15) im wesentlichen ohne Spiel in der Befestigungsöffnung (13) fixiert wird als auch durch ein entstehendes Drehmoment so gegen die Betätigungskraft (15) vorgespannt wird, daß der Schalter (1) im Bereich der Lötanschlüsse (9) an der Leiterplatte (8) fixiert ist.

5. Elektrischer Schalter nach einem der Ansprüche 1 bis 4, **dadurch gekennzeichnet, daß** der Schalter (1) mit seiner zweiten Seite (5) im wesentlichen parallel zu der Leiterplatte (8) angeordnet ist, insbesondere derart daß die Betätigungskraft (15) im wesentlichen parallel zur Leiterplatte (8) gerichtet ist.

6. Elektrischer Schalter nach einem der Ansprüche 1 bis 5, **dadurch gekennzeichnet, daß** die erste Seite (4) sowie die zweite Seite (5) zueinander benachbart sind, insbesondere zueinander in etwa rechtwinklig stehen, und daß das Abstützelement (10, 10') im wesentlichen am Übergang von der ersten Seite (4) zur zweiten Seite (5) am Gehäuse (2) angeordnet ist.

7. Elektrischer Schalter nach einem der Ansprüche 1 bis 6, **dadurch gekennzeichnet, daß** der Rasthaken (12) an der zweiten Seite (5) des Gehäuses (2) zwischen den Abstützelementen (10, 10') und den elektrischen Anschlüssen (7) angeordnet ist.

8. Elektrischer Schalter nach einem der Ansprüche 1 bis 7, **dadurch gekennzeichnet, daß** das Gehäuse (2) im wesentlichen quaderförmig ausgestaltet ist, daß das Gehäuse (2) topfförmig mit einer der ersten Seite (4) zugewandten Öffnung (19) ausgebildet ist, und daß weiter die die Öffnung (19) verschließende erste Seite (4) integraler Bestandteil des Betätigungsorgans (6) ist.

## Claims

1. An electric switch having a housing (2), with a contact system (3) being located In the housing (2), with an actuating member (6) projecting from the housing (2) at a first side (4) for the switching effect on the contact system (3), and with electric connections (7) for the contact system (3), which project from the housing (2) at a second side (5), wherein the electric connections (7) may be attached on a printed circuit board (8), and wherein at least one support element (10, 10') is located on the second side (5) of the housing (2) such that the switch (1) is mainly fixed on the printed circuit board (8) in the area of the connections (7) after assembly of the switch (1) on the printed circuit board (8), **characterized in that** the support element (10, 10') is embodied in an elastic manner, and consists of a spring element (17), as well as of a spacer element (18).

2. The electric switch according to claim 1, **characterized in that** the electric connections (7) are attached on the printed circuit board (8) by means of producing an electric connection at solder joints (9).

3. The electric switch according to claims 1 or 2, **characterized in that** the support element (10, 10') is part of an attachment system (14), wherein the attachment system (14) consists of an engagement hook (12) for the engagement of the switch (1) in an attachment opening (13) on the printed circuit board (8), as well as of the support elements (10, 10') elastically adjacent to the printed circuit board (8).

4. The electric switch according to claim 3, **characterized in that** the engagement hook (12) and the elastic support element (10, 10") interact with each other such that with the installation on the printed circuit board (8) the switch (1) is fixed in the attachment opening (13) essentially without any clearance, both in the direction of the actuating force (15) acting upon the actuating element (6) at the actuation thereof, and is also pre-tensioned by means of a torque created against the actuating force (15) such that the switch (1) is fixed in the area of the solder joints (9) on the printed circuit board (8).

5. The electric switch according to one of the claims 1 to 4, **characterized in that** the switch (1) is disposed at its second side (5) essentially parallel to the printed circuit board (8), in particular such that the actuating force (15) is essentially directed parallel to the printed circuit board (8).

6. The electric switch according to one of the claims 1 to 5, **characterized in that** the first side (4) and the second side (5) are adjacent to each other, in particular are approximately at a right angle to each other, and that the support element (10, 10') is disposed essentially at the transition from the first side (4) to the second side (5) at the housing (2).

7. The electric switch according to one of the claims 1 to 6, **characterized in that** the engagement hook (12) is disposed on the second side (5) of the housing (2) between the support elements (10, 10') and the electric connections (7).

8. The electric switch according to one of the claims 1 to 7, **characterized in that** the housing (2) is embodied essentially prismatically, such that the housing (2) is embodied in a cup-shaped manner with an opening (19) facing the first side (4), and that further the first side (4) closing the opening (19) is an integral part of the actuating element (6).

## Revendications

1. Interrupteur électrique avec un boîtier (2), avec un système de contact (3) disposé dans le boîtier (2), avec un élément d'actionnement (6) dépassant du boîtier (2) sur un premier côté (4), pour une action de commutation sur le système de contact (3), et avec des raccordements électriques (7) dépassant du boîtier (2) sur un deuxième côté (5), pour le système de contact (3), les raccordements électriques (7) pouvant être fixés sur une carte de circuit imprimé (8) et au moins un élément d'appui (10, 10') se trouvant sur le deuxième côté (5) du boîtier (2), de façon à ce que l'interrupteur (1) soit fixée fermement sur la carte de circuit imprimé (8) au niveau des raccordements (7) après le montage de l'interrupteur (1) sur la carte de circuit imprimé (8), **caractérisé en ce que** l'élément d'appui (10, 10') est conçu de manière élastique et est constitué d'un élément à ressort (17) ainsi que d'un élément d'écartement (18).

2. Interrupteur électrique selon la revendication 1, **caractérisé en ce que** les raccordements électriques (7) sont fixés sur la carte de circuit imprimé (8) en établissant une liaison électrique au niveau de soudures (9).

3. Interrupteur électrique selon la revendication 1 ou 2, **caractérisé en ce que** l'élément d'appui (10, 10') est une partie du système de fixation (14), le système de fixation (14) étant constitué d'un crochet d'encliquetage (12) pour l'encliquetage de l'interrupteur (1) dans une ouverture de fixation (13) sur la carte de circuit imprimé (8) ainsi que d'éléments d'appui (10, 10') appuyés de manière élastique sur la carte de circuit imprimé (8).

4. Interrupteur électrique selon la revendication 3, **caractérisé en ce que** le crochet d'encliquetage (12) et l'élément d'appui élastique (10, 10') interagissent de façon à ce que l'interrupteur (1) soit fixé lors du montage sur la carte de circuit Imprimé (8) dans la direction de la force d'actionnement (15) agissant sur l'élément d'actionnement (6) lors de son actionnement, sensiblement sans jeu dans l'ouverture de fixation (13), et précontraint l'aide d'un couple résultant contre la force d'actionnement (15) de façon à ce que l'interrupteur (1) soit fixé sur la carte de circuit imprimé (8) au niveau des soudures (9).

5. Interrupteur électrique selon l'une des revendications 1 à 4, **caractérisé en ce que** l'interrupteur (1) est disposé, avec son deuxième côté (5), sensiblement parallèlement à la carte de circuit imprimé (8), plus particulièrement de façon à ce que la force d'actionnement (15) soit essentiellement parallèle à la carte de circuit imprimé (8).

6. Interrupteur électrique selon l'une des revendications 1 à 5, **caractérisé en ce que** le premier côté (4) ainsi que le deuxième côté (5) sont adjacents, plus particulièrement sont disposés à angle droit entre eux et **en ce que** l'élément d'appui (10, 10') est disposé sur le boîtier (2), essentiellement sur la transition entre le premier côté (4) et le deuxième côté (5).

7. Interrupteur électrique selon l'une des revendications 1 à 6, **caractérisé en ce que** le crochet d'encliquetage (12) se trouve sur le deuxième côté (5) du boîtier (2) entre les éléments d'appui (10, 10') et les raccordements électriques (7).

8. Interrupteur électrique selon l'une des revendications 1 à 7, **caractérisé en ce que** le boîtier (2) présente essentiellement une forme parallélépipédique, **en ce que** le boîtier (2) est conçu sous la forme d'un cloche avec une ouverture (19) orientée vers le premier côté (4) et **en ce que** le premier côté (4) fermant l'ouverture (19) fait partie intégrante de l'élément d'actionnement (6).
